# EUROPEAN PATENT SPECIFICATION

(11) **EP 0 531 538 B1**
(45) Date of publication and mention of the grant of the patent: **15.04.1998**
(21) Application number: 92906204.0
(22) Date of filing: 28.02.1992
(51) Int. Cl.: H03M 7/30, H04B 1/66

(54) **Reduction of the size of side-information for Subband coding**
Reduzierung der Zusaztinformation bei Teilbandkodierungsverfahren
Reduction de la taille d'information de formatage pour codage par sous-bandes

(30) Priority: 29.03.1991 JP 91187/91; 29.03.1991 JP 91188/91
(43) Date of publication of application: 17.03.1993
(73) Proprietor: SONY CORPORATION, Tokyo 141 (JP)
(72) Inventor: AKAGIRI, Kenzo, Shinagawa-ku, Tokyo 141 (JP)
(74) Representative: Harris, Ian Richard
(86) International application number: PCT/JP92/00237
(87) International publication number: WO 92/17942

(56) References cited:
- EP-A- 0 064 119
- JP-A- 3 060 529
- JP-A- 3 117 921
- JP-A- 3 121 624
- JP-A- 3 132 218
- JP-A-60 237 738
- IEEE JOURNAL ON SELECTED AREAS IN COMMUNICATION., vol.6, no.2, February 1988, NEW YORK US pages 314 - 323 J. JOHNSTON 'TRANSFORM CODING OF AUDIO SIGNALS USING PERCEPTUAL NOISE CRITERIA'
- IEEE INTERNATIONAL CONFERENCE ON COMMUNICATIONS, vol.3, 15 April 1990, NEW YORK pages 937 - 941 STOLL ET AL. 'HIGH QUALITY AUDIO BIT-RATE REDUCTION SYSTEM FAMILY FOR DIFFERENT APPLICATIONS'

## Description

### Technical Field

This invention relates to an efficient coding method or apparatus for a digital audio signal, which is adapted to carry out coding of an input digital signal.

### BACKGROUND ART

In an efficient coding of audio signals, or sound signals, etc., there is known a coding technology based on bit allocation to divide an audio or sound signal, etc. into signal components of a plurality of channels on the time base or frequency base, and to adaptively allocate the number of bits every respective channels. As the coding technology based on the above-mentioned bit allocation of, e.g., an audio signal, etc., there are coding technologies such as a band divisional coding (sub-band coding: SBC) to divide an audio signal, etc. on the time base into signal components in a plurality of frequency band to carry out coding thereof, an adaptive transform coding (ATC) to transform (orthogonally transform) a signal on the time base to a signal on the frequency base to divide it into signal components in a plurality of frequency bands to adaptively carry out coding every respective bands, so called an adaptive bit allocation (APC-AB) coding in which the SBC and the so-called adaptive predictive coding (APC) are combined to divide a signal on the time base into signal components in frequency bands to convert signal components in respective bands to those in base bands (low frequency bands) thereafter to carry out a linear predictive analysis of plural orders to carry out a predictive coding, and the like.

In the above-mentioned efficient coding, an approach is employed to transform an audio signal, etc. on the time base to that on the base (frequency base) orthogonal to the time base by orthogonal transform, e.g., fast Fourier transform (FFT) or DCT, etc. every predetermined unit time and thereaffer divide the signal on the frequency base to signal components in a plurality of bands to encode coefficient data in the respective divided bands by the adaptive bit allocation. This coded data is transmitted.

Meanwhile, in encoding coefficient data every respective bands by the above-mentioned adaptive bit allocation, an approach is frequently employed to divide, e.g., coefficient data on the frequency base into data every blocks to implement the so-called block floating processing every blocks to further carry out bit compression. For this reason, as the configuration for decoding subsequent thereto, there is employed a system configuration such that coefficient data subjected to band division and block floating processing every blocks and subinformation comprised of floating coefficients every respective blocks and word length information corresponding to floating coefficients and the number of allocated bits every respective blocks are transmitted.

However, in the above-mentioned efficient coding, it is desirable to further increase the compression efficiency.

With the above-described actual circumstances in view, this invention has been proposed, and its object is to provide a coding method for a digital signal, which is capable of carrying out bit compression to higher degree.

A coding method for a digital signal according to this invention has been proposed in order to attain the above-described object, and is directed to a coding method for a digital signal, which is adapted to orthogonally transform an input digital signal to divide the orthogonally transformed signal to signal components in critical frequency bands to encode the signal components in the respective critical bands by the number of bits corresponding levels indicative of differences between allowed noise levels every critical bands set on the basis of energies every critical bands and energies every respective critical bands, and to divide the orthogonally transformed signal components into those every blocks to implement block floating processing every blocks to transmit floating coefficients every blocks.

Thus, in the case of carrying out the block floating processing every small block of which bandwidth is narrower than that of the critical band, information relating to allowed noise levels are transmitted in place of floating coefficients every critical band, and information of word lengths corresponding to the numbers of bits allocated every small blocks is transmitted.

Further, in the case where the block floating processing is carried out every large block of which bandwidth is broader to that of the critical band, information relating to floating coefficients every large blocks are transmitted, and information of word lengths corresponding to the numbers of bits allocated every critical band are transmitted.

Furthermore, in the case where the block floating processing is carried out every small block of which bandwidth is narrower than that of the critical band, word length information corresponding to the number of bits allocated with respect to one small block of small blocks in respective critical bands is transmitted. On the other hand, in the case of carrying out the block floating processing every large block of which bandwidth is broader than that of the critical band, word length information in one critical band of critical bands in the large block and information relating to allowed noise levels in respective critical bands may be transmitted.

In addition, in place of transmitting information relating to floating coefficients every critical bands, information relating to allowed noise levels each of which designation range is shifted in a lower level direction by a predetermined level from a signal level range in the critical band may be transmitted.

Here, in determination of the number of allocated bits, it is desirable to employ an approach to determine so called a masking quantity from energies every respective critical bands in consideration of the hearing sense characteristic of the human being to determine the numbers of allocated bits every respective critical bands by using allowed levels based on the masking quantity.

### DISCLOSURE OF THE INVENTION

In accordance with this invention, in the case of carrying out floating processing every small blocks of which bandwidth is narrower than that of the critical band, an approach is employed to transmit, in place of floating coefficients every respective critical band, information relating to allowed noise levels every critical bands and word length information of respective small blocks, thereby making it possible to reduce the number of bits for the floating coefficients. Further, in the case of carrying out the block floating processing every large blocks of which bandwidth is broader than that of the critical band, an approach is employed to transmit information relating to floating coefficients every large blocks, thereby making it possible to reduce the number of bits transmitted.

Furthermore, in the case of carrying out the floating processing every small block of which bandwidth is narrower than that of the critical band, an approach is employed to transmit word length information of one small block of small blocks in respective critical bands, thereby making it possible to reduce the number of word length information. Accordingly, bit compression can be carried out to higher degree.

In addition, in the case of carrying out the floating processing every small blocks of which bandwidth is narrower than that of the critical band, an approach is employed to transmit information of word lengths corresponding to the numbers of bits allocated every small blocks, and to transmit, in place of floating coefficients every critical bands, information relating to allowed noise levels each of which designation range is shifted in a lower level direction by a predetermined level from a signal level range in the critical bands, thereby making it possible to reduce the number of bits for transmission of information relating to allowed noise levels. Accordingly, bit compression can be carried out to higher degree.

### BRIEF DESCRIPTION OF THE DRAWINGS

Fig. 1-A is a view for explaining the case where a floating processing of this invention is carried out every block of which bandwidth is narrower than that of the critical band.

Fig. 1-B is a view for explaining the case where a floating processing of this invention is carried out every block of which bandwidth is broader than the critical band.

Fig. 2 is a flowchart of an embodiment of this invention.

Fig. 3 is a circuit diagram showing, in a block form, an actual configuration for setting allowable noises.

Fig. 4 is a view showing a bark spectrum.

Fig. 5 is a view showing a masking spectrum.

Fig. 6 is a view in which a minimum audible curve and a masking spectrum are synthesized.

Fig. 7 is a view for explaining allowed noise levels transmitted of respective blocks of this embodiment.

### BEST MODE FOR CARRYING OUT THE INVENTION

A preferred embodiment to which this invention is applied will now be described with reference to the attached drawings.

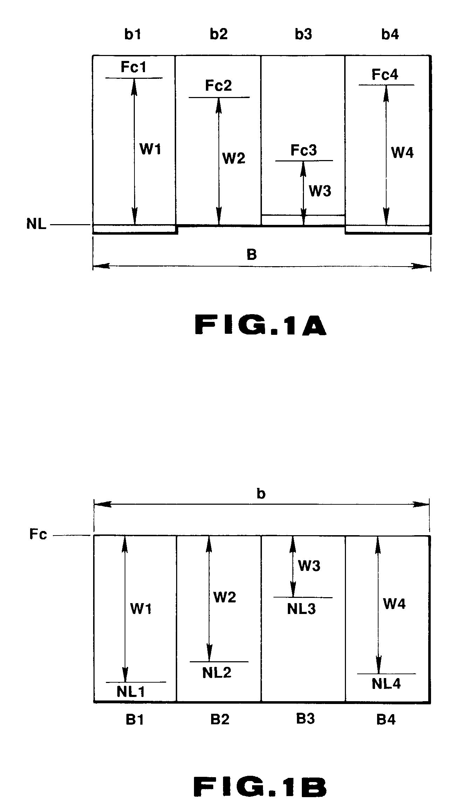

A coding method for a digital signal according to this invention is directed to a coding method for a digital signal, as shown in Figs. 1A and B, which is adapted to orthogonally transform an input digital signal by using, e.g., fast Fourier transform (FFT) or DCT to divide the orthogonally transformed signal to signal components in a critical frequency band B (B1 to B4) such that according as the frequency shifts to a higher frequency side, the bandwidth becomes broader in consideration of the hearing sense of the human being to encode the signal components in the respective critical bands by the numbers of bits corresponding levels indicative of differences between an allowed noise level NL every critical band set on the basis an energies every critical bands and energies every respective critical bands, and to divide the orthogonally transformed signal components into those in blocks to implement block floating processing every blocks b to transmit floating coefficients Fc every block b.

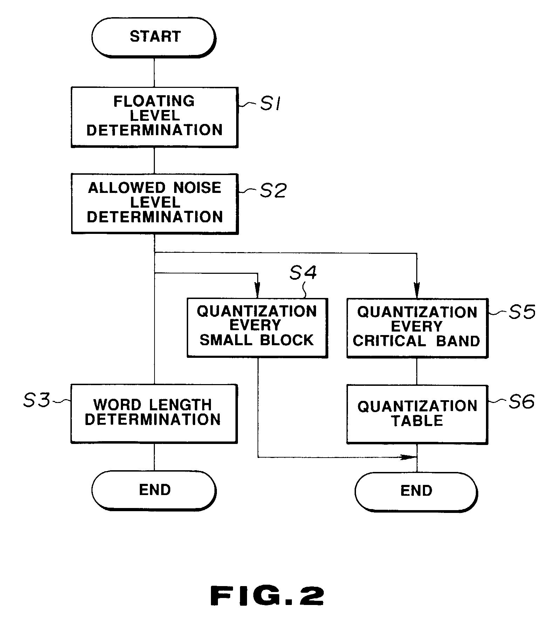

In other words, in this embodiment, a processing as shown in the flowchart of FIG. 2 is carried out. First, at step S1, the orthogonally transformed signal components are divided into those in blocks to carry out block floating processing every blocks, thus to determine floating coefficients (floating levels) every blocks. At step S2, allowed noise levels every respective critical bands set on the basis of energies every critical bands as described later are determined. At step S3, information of word lengths corresponding to the numbers of allocated bits set on the basis of levels indicative of differences between allowed noise levels every critical bands and energies every respective critical bands are determined.

Here, in this embodiment, for example, as shown in FIG. 1-A, in the case of carrying out the block floating processing every small blocks (small blocks b1 to b4) having a bandwidth narrower than that of the critical band B, an approach is employed to transmit, in place of floating coefficients every critical band B, information relating to an allowed noise level NL and information of word lengths W1 to W4 corresponding to the numbers of bits allocated every small blocks b1 to b4.

Further, for example, as shown in FIG. 1-B, in the case of carrying out the block floating processing every large block (large block b) having a bandwidth broader than that of the critical bands B1 to B4, an approach is employed to transmit information relating to floating coefficients every large block b, and to transmit information of word lengths W1 to W4 corresponding to the number of bits allocated every critical bands B1 to B4.

It is to be noted that, in the example of Fig. 1-A, one critical band B on the higher frequency band side of a broad bandwidth of the critical band is extracted and illustrated. The example of Fig. 1-B shows respective bands on a lower frequency side of a narrow bandwidth. In addition, in Fig. 1-A, B, because level differences for determining the allocated bit number and the word lengths W1 to W4 correspond to each other, only the word lengths W1 to W4 are illustrated for convenience.

Further, in this embodiment, as previously described, coding processing for FFT coefficient data by the adaptive bit allocation is carried out. Namely, the coding processing by adaptive bit allocation in this embodiment determines so called a masking quantity in consideration of the hearing sense characteristic of the human being as described later on the basis of energies every respective critical bands to determine the numbers of allocated bits corresponding to a level indicative of a difference between an allowed noise level set on the basis of the masking quantity (i.e., substantially fixed allowed noise every respective critical bands) and energies in respective critical bands, thus to carry out coding in dependency upon the numbers of allocated bits every respective critical bands.

Furthermore, a plurality of coefficient data in the respective critical bands constitute blocks every a fixed number of coefficient data to implement the so-called block floating processing every respective blocks to carry out bit compression. Accordingly, as in the example of Fig. 1-A, there will exist a plurality of blocks (e.g., four small blocks b1 to b4) in a critical band B of a higher frequency side, i.e., broad bandwidth of the critical band. Further, as in the case where the bandwidth is narrow (lower frequency band of the critical band) is narrow, there will exist a plurality of critical bands (e.g., four critical bands B1 to B4) in a large block b.

Meanwhile, if block floating processing is ordinarily implemented in this way, floating coefficients for the floating processing and information of word lengths corresponding to the numbers of the allocation bit number are required in a decoding processing carried out later. Namely, as the configuration for subsequent decoding, it is required to employ a system configuration to transmit information of floating coefficients every blocks and information of word lengths corresponding to allocation bit numbers based on level differences between levels of the floating coefficients and allowed noise levels of the critical bands. In other words, in the subsequent decoding, a most significant bit (MSB) in the block floating processing is determined from information of the floating coefficients. Likewise, a least significant bit (LSB) is determined from information of the word length. Thus, the allowed noise levels are determined. In addition, the magnitude of a signal is determined from coefficient data (main data) of respective blocks.

Here, information of the floating coefficients is ordinarily represented by 6 bits, and information of word lengths are represented by 4 bits, respectively. It is to be noted that in the case where the orthogonal transformation is DFT (discrete Fourier transform), the above-mentioned word information is such that the magnitude (amplitude) and the phase, or the real part and the imaginary part are represented by 4 bits. For this reason, for example, in the case where one critical band is divided by a plurality of floating blocks, the number of bits transmitted of the entire critical band corresponding to the number of blocks (i.e., the number of division of bands) of the block floating processing is as shown in Table 1.

**TABLE 1**

| NO. OF REDIVISIONS OF CRITICAL BAND | 1 | 2 | 3 | 4 |
|---|---|---|---|---|
| FLOATING COEFICIENT INFORMATION | 6 | 6x2 | 6x3 | 6x4 |
| WORD LENGTH INFORMATION | 4 | 4x2 | 4x3 | 4x4 |
| TOTAL | 10 | 20 | 30 | 40 |

In this Table 1, in the case where the critical band is represented by a single block (one division: the number of division is 1), 10 bits in total of 6 bits for the floating coefficient and 4 bits for the word length are transmitted. Further, in the case where the critical band is represented by two blocks (two divisions), 20 bits in total of 6 x 2 (= 12) bits for the floating coefficient and 4 x 2 (= 8) bits for the word length are transmitted. Similarly, in the case of three divisions, 30 bits in total of 6 x 3 (= 18) bits for the floating coefficient and 4 x 3 (= 12) bits for the word length are transmitted. Further, in the case of four divisions (example of Fig. 1-A), 40 bits in total of 6 x 4 (= 24) bits for the floating coefficient and 4 x 4 ( = 16) bits for the word length are transmitted. As described above, according as the number of blocks in a single critical band increases, the number of bits transmitted also increases.

On the contrary, in the example of FIG. 1-A of the embodiment of this invention, an approach is employed to transmit information of the allowed noise level NL set by only one with respect to the critical band B and information of word lengths W1 to W4 corresponding to the allocation bit number without transmitting information of floating coefficients Fc1 to Fc4 of respective small blocks in the critical band B. Namely, in the subsequent decoding processing, if information of the allowed noise level NL of the critical band B is transmitted, information of floating coefficients Fc1 to Fc4 every respective small blocks b1 to b4 can be determined on the basis of information of the allowed noise level NL and information of word lengths W1 to W4 of the respective small blocks b1 to b4. For this reason, a scheme is employed in this case such that no information of floating coefficients Fc1 to Fc4 is transmitted. Thus, the number of bits for transmitting four necessary floating coefficients Fc1 to Fc4 with respect to the critical band B can be reduced.

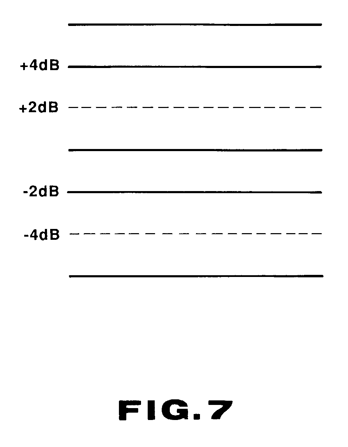

Here, the allowed noise level NL is determined every critical band in consideration of the hearing sense characteristic of the human being. In the critical band, it can be considered that the allowed noise level NL is substantially constant within one critical band. Accordingly, it is similarly considered that the allowed noise level NL is the same level also in respective blocks b1 to b4 within the critical band B of FIG. 1-A. It is to be noted that when the entire dynamic range is, e.g., 120 dB and the floating coefficient is represented by 6 bits, the floating coefficient has an accuracy of about 2 dB, and when the word length information is represented by 4 bits, the word length information has an accuracy of about 6 dB. For this reason, in the respective small blocks b1 to b4 of FIG. 1-A, in the subsequent decoding, the allowed noise level determined by information of the floating coefficients Fc1 to Fc4 and the word lengths W1 to W4 has a deviation or shift of about 2 dB as shown in Fig. 7. However, the allowed noise level NL ordinarily falls within the range of substantially +3B. In view of this, in this embodiment, a scheme is employed to represent the allowed noise level NL by a two-stage quantization of a rough quantization common in the critical bands and a fine quantization that respective small blocks of the floating processing in the critical blocks have, thus to set the allowed noise level NL as a common value with high accuracy. Namely, in this embodiment, since the allowed noise level NL is 4 bit log level, the allowed noise level NL which fails to be represented by the 4 bit log is finely represented by 2 bit log. Accordingly, in this embodiment, about 6 dB is divided by four, thus permitting the allowed noise level to have an accuracy of 1.5 dB. As stated above, attention is drawn to the fact that respective allowed noise levels NL are substantially equal over a plurality of small blocks to select a high accuracy parameter from the floating coefficients and the allowed level, thereby making it possible to reduce the number of bits. The manner of reduction in the number of bits in the example of Fig. 1-A is shown in Table 2 by comparison with Table 1.

**TABLE 2**

| NO. OF REDIVISIONS OF CRITICAL BAND | 1 | 2 | 3 | 4 |
|---|---|---|---|---|
| ALLOWED NOISE LEVEL | 4+2 | 4+ 2x3 | 4+ 2x3 | 4+ 2x4 |
| WORD LENGTH INFORMATION | 4 | 4x2 | 4x3 | 4x4 |
| TOTAL | 10 | 16 | 22 | 28 |
| ASSUMING THAT EXAMPLE OF TABLE 1 IS 100 % | 100 | 80 | 73 | 70 |

In Table 2, in the case where the critical band B is represented with a single block (one division), 4 bits for the allowed noise level NL and 4 bits for the word length W are transmitted. It is to be noted that, at the allowed noise level NL, as described above, 2 bits for compensating deviation of 2 dB is added (4 + 2 bits). For this reason, in the case of the one division, 10 bits in total are transmitted. Likewise, in the case where the critical band B is represented with two small blocks (two divisions), 16 bits in total of 4 + 2 x 2 = 8 bits for the allowed noise level and 4 x 2 = 8 bits for the word length W are transmitted. Similarly, in the case of three divisions, 22 bits in total of 4 + 2 x 3 = 10 bits for the allowed noise level NL and 4 x 3 = 12 bits for the word length W are transmitted. In addition, in the case of the four divisions (the example of Fig. 1-A), 28 bits in total of 4 + 2 x 4 = 12 bits for the allowed noise level NL and 4 x 4 = 16 bits for the word length are transmitted. For this reason, when the number of bits transmitted of the example of the Table 1 is assumed to be 100% and comparison with the example of the Table 2 is made, in the case of the example of the Table 2, that bit number is equal to 100% which is the same as in the case of one division, whereas according as the number of divisions (the number of blocks) increases, the bit reduction rate is improved to such a degree that the number of bits transmitted is 80% in the case two divisions, is 73% in the case of three divisions, and is 70% in the case of four divisions. Accordingly, it can be seen that the method of this embodiment is very effective.

It is to be noted that quantization of information of word lengths W1 to W4 is of a nature to be not adaptive but uniform.

Further, as compared to the case where the floating processing is carried out every small block of which bandwidth is narrower than that of the critical band as shown in Fig. 1-A, in the case where, e.g., the block floating-processing is carried out every large blocks of which bandwidth is broader than that of the critical band, also in the subsequent decoding, information of block floating coefficients every respective critical bands and the word lengths determined every respective critical bands are ordinarily required. On the contrary, in this embodiment, in the case of carrying out the block floating processing every large block b of which bandwidth is broader than that of the critical band as shown in Fig. 1-B, information of the floating coefficient Fc of one large block and information of word lengths W1 to W4 determined every critical bands B1 to B4 are transmitted as information relating to the floating coefficient. It is to be noted that information of allowed noise levels NL1 to NL4 of the respective critical bands B1 to B4 are not transmitted. Namely, since floating coefficients Fc are equal to each other in the respective critical bands B1 to B4, it is possible to determine the allowed noise levels NL1 to NL4 from information of one floating coefficient Fc and information of word lengths W1 to W4 every critical bands. Accordingly, by transmitting, as subinformation, only information of the floating coefficient Fc and information of respective word lengths W1 to W4, it is possible to further reduce the number of bits for subinformation as compared to an ordinary case.

Further, in the example of Fig. 1-A, a scheme may be employed such that only information of word length W1 of respective word lengths W1 to W4 in one critical band B is transmitted, and information of other word lengths W2 to W4 are not transmitted. Namely, only information of respective floating coefficients Fc1 to Fc4 in the critical band B and information of the word length W1 are transmitted. In other words, in the subsequent decoding processing, if information of one word length is transmitted, it is possible to determine information of remaining word lengths W2 to W4 on the basis of information of respective floating coefficients Fc1 to Fc4. In actual terms, if the allowed noise level NL can be determined by the floating coefficient Fc1 and the word length W1, it is possible to know the remaining word lengths W2 to W4 from the allowed noise level NL and the floating coefficients Fc2 to Fc4. For such reason, an efficient simplified scheme may be employed such that information of the remaining word lengths W2 to W4 are not transmitted. Accordingly, it is possible to reduce the number of bits for transmission of information of three word lengths w2 to W4 with respect to the critical band B.

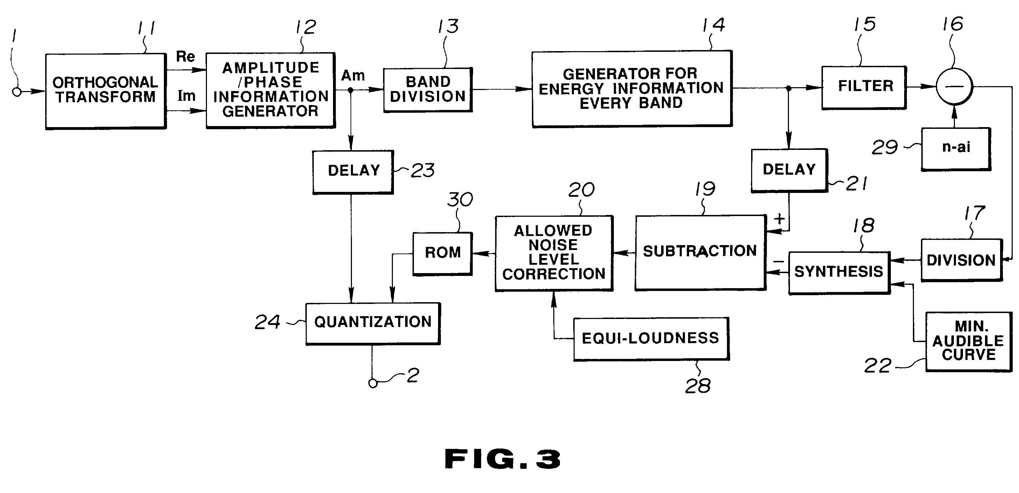

The manner of reduction in the number of bits of the example of Fig. 1-B is shown in FIG. 3 by comparison with the Table 3.

**TABLE 3**

| UNITY NO. OF CRITICAL BAND | 1 BAND | 2 BAND | 3 BAND | 4 BAND |
|---|---|---|---|---|
| FLOATING COEFFICIENT INFORMATION | 6 | 6 | 6 | 6 |
| WORD LENGTH INFORMATION | 4 | 4 x2 | 4 x3 | 4 x4 |
| TOTAL | 10 | 14 | 18 | 22 |
| ASSUMING THAT EXAMPLE OF TABLE 1 IS 100 % | 100 | 70 | 60 | 55 |

In this Table 3, explanation will be given by using the number of critical bands united or joined (unity number) in one block b. In the case where the number of bands united in one block b is 1 (1 band), 10 bits in total of 6 bits for information with respect to the level of the floating coefficient Fc and 4 bits for the word length W are transmitted. Likewise, in the case where the number of critical bands is 2 (two bands), 14 bits in total of 6 bits for the floating coefficient Fc and 4 x 2 = 8 bits for the word length W are transmitted. Similarly, in the case of three bands, 18 bits in total of 6 bits for the floating coefficient Fc and 4 x 3 = 12 bits for the wordlength W are transmitted. In addition, in the case of four bands (example of Fig. 1-B), 22 bits in total of 6 bits for the floating coefficient Fc and 4 x 4 = 16 bits for the word length are transmitted. For this reason, when the number of bits transmitted of the example of Table 2 is assumed to be 100% and comparison with Table 3 is made, in the case of the example of Table 3, the number of bits transmitted is 100% for one band which is the same as in the case of the example of Table 1, whereas the bit reduction rate is improved according as the number of bands increases to such a degree that bit number is 70% for two bands, 60% for three bands, and 55% for four bands. Accordingly, it can be seen that the method of this embodiment is very effective.

Here, in the embodiment of this invention, in the case where the block floating processing is carried out every small block of which bandwidth is narrower than that of the critical band, at the step S4, information of word lengths corresponding to the number of bits allocated every small blocks are determined and transmitted; and at steps S5 and S6, information relating to the allowed noise level of which designation range is shifted in a lower level direction by a predetermined level (level based on a masking quantity which will be described later) from the signal level range in the critical range are determined and transmitted in place of floating coefficients every critical bands. To speak more practically, a quantization Table in which such values to shift the designation range in a lower level direction by the above-mentioned predetermined level from the signal level range in the critical band are stored is used to output and transmit a value corresponding to the allowed noise level determined at the step S2.

As described above, the reason why the designation range of the allowed noise level is shifted is as follows. First, in the case of transmitting information relating to the allowed noise level determined at the step S2 as it is, it is ineffective or useless to use, for the allowed noise level, the same index as that of the dynamic range that an actual signal can take. Namely, since the allowed noise level is determined on the basis of a masking quantity in which the hearing sense characteristic of the human being is taken into consideration as described later, it will becomes equal to a value by a predetermined level lower than the maximum value of the above mentioned actual signal level. For example, the allowed noise level is taken so that it is lower than the signal level by about 26 dB. As stated above, it is extremely ineffective or useless to use the dynamic range that the signal level can take as it is for the allowed noise level taken so that it is necessarily lower than the signal level by a certain fixed level. In addition, this is not preferable in view of reduction in the number of bits. For such a reason, in this embodiment, there is used a quantization Table such that the designation range is shifted in a lower level direction by a predetermined level from the signal level range in the critical range. Thus, even by less number of bits, the allowed noise level can be represented. In other words, even by less number of bits, the allowed noise level can be represented with the same resolution (accuracy) as in the case where no shift is carried out. Accordingly, it is possible to reduce the number of bits for transmission of the allowed noise level.

Meanwhile, for the subsequent decoding processing, a difference between a transmission noise level of the small block b1 giving the word length W1 and a level closest to the allowed noise level NL is transmitted together. Namely, as information indicating a difference between the allowed noise level NL and a level closest thereto, information indicating where the transmission noise levels of respective small blocks fall within the range of substantially +3 dB may be transmitted by using judgment bit information of, e.g., 2 bits. For example, it is indicated that when the judgment bit information of 2 bits is "00", the transmission noise level is shifted to the + (plus) side (+1); when that information is "01", that noise level has no shift (0); and when that information is "10", that noise level is shifted to the - (minus) side (-1). It is to be noted that "11" is not used, or indicates that the transmission noise level is not changed.

Thus, a transmission noise level of the small block b1 is determined from information of the floating coefficient Fc1 and the word length W1. Further, a difference between the allowed noise level NL and a level closest thereto (level difference indicated by the judgment bit) is added to the allowed noise level NL, thereby making it possible to provide a level closest to the allowed noise level. At this time, since the transmitted noise levels of the respective small blocks b1 to b4 are not shifted beyond a level adjacent to the level closest to the allowed noise level NL, it is possible to determine respective word lengths W2 to W4 from the respective floating coefficients Fc2 to Fc4.

The manner of reduction in the number of bits in the example of FIG. 1 is shown in Table 4 by comparison with the Table 1.

**TABLE 4**

| NO. OF REDIVISIONS OF CRITICAL BAND | 1 | 2 | 3 | 4 |
|---|---|---|---|---|
| FLOATING COEFFICIENT INFORMATION | 6 | 6x2 | 2x3 | 6x4 |
| WORD LENGTH INFORMATION | 4 | 4 | 4 | 4 |
| JUDGEMENT BIT | (2) | 2 | 2 | 2 |
| TOTAL | 10 | 18 | 24 | 30 |
| ASSUMING THAT EXAMPLE OF TABLE 1 IS 100 % | 100 | 90 | 80 | 75 |

In this Table 4, in the case where the critical band B is represented by a single small block (divisions), 6 bits for the floating coefficient and 4 bits for the word length W are transmitted. It is to be noted that the above-mentioned judgment bit (2 bits) is not used in this case. For this reason, in the case of one division, 10 bits in total are transmitted. Likewise, in the case where the critical band B is represented by two small blocks b (two divisions), 18 bits in total of 6 x 2 = 12 bits for the floating coefficient, 4 bits for the word length W and 2 bits for the judgment bit information are transmitted. Similarly, in the case of three divisions, 24 bits in total of 6 x 3 = 18 bits for the floating coefficient, 4 bits for the word length W and 2 bits for the judgment bit information are transmitted. In addition, in the case of four divisions (example of FIG. 1), 30 bits in total of 6 x 4 = 24 bits for the floating coefficient, 4 bits for the word length W and 2 bits for the judgment bit information are transmitted. For this reason, when the transmitted bit number of the example of Table 1 is 100% and comparison with the example of Table 4 is made, in the case of the example of Table 4, when the number of divisions is 1, the transmitted bit number is 100% which is the same as in the case of Table 1, whereas according as the number of divisions (the number of small blocks) increases, the bit reduction rate is improved to such a degree that the transmitted bit number is 90% when the number of divisions is 2, 80% when that number is 3, and 75% when that number is 4. Accordingly, it can be seen that the method of this embodiment is extremely effective.

It is to be noted that, in the above-mentioned respective embodiments, the level which can take as the allowed noise level NL is smaller than the dynamic range. Namely, since the minimum value of S/N is about 30 dB, there is no possibility that the allowed noise level enters the region of about 30 dB from the peak value (0 dB) of the dynamic range. Thus, such a setting can be made in the encoder.

An example of the configuration to which the coding method of this embodiment is applied, which is adapted to determine the above-described allowed noise levels to further encode signals by the allocated bit number based on the allowed noise levels, is shown in FIG. 3.

Namely, in FIG. 3, digital audio data on the time base delivered to an input terminal 1 is transmitted to an orthogonal transform circuit 11. At this orthogonal transform circuit 11, the audio data on the time base is transformed to data on the frequency base every unit time (unit block). Thus, coefficient data comprised of a real component value Re and an imaginary component value Im are provided. These coefficient data are transmitted to an amplitude phase/information generator 12. At the amplitude phase information generator 12, amplitude information Am and phase information Ph are provided from the real component value Re and the imaginary component value Im. Only the amplitude information Am is outputted therefrom. Namely, since the hearing sense of the human being is generally sensitive for the amplitude (power) of the frequency region, but is considerably dull for the phase, only the amplitude information Am is used in this embodiment to provide the allocated bit number information.

The amplitude information Am is first transmitted to a band divider 13. This band divider 13 divides an input digital signal represented by the amplitude information Am into the so-called critical bands. This critical band is determined by taking into consideration the hearing sense characteristic (frequency analysis ability) of the human being. For example, a signal of the frequency band of 0 to 22 KHz is divided into 25 bands to make a setting such that the band width becomes broader according as the frequency shifts to a higher frequency side. Namely, the hearing sense of the human being has a characteristic such as a sort of band-pass filter, and bands divided by respective filters are called a critical band.

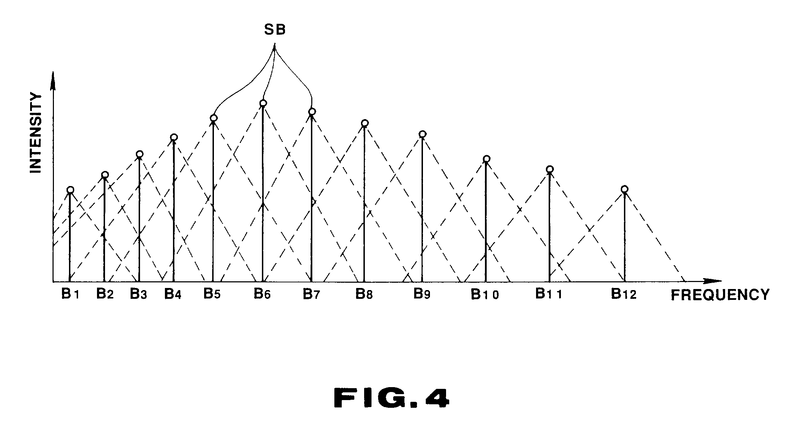

The amplitude information Am every respective bands divided into critical bands by the band divider 13 are respectively transmitted to a sum total detector 14. At this sum total detector 14, energies every respective bands (spectrum intensities in respective bands) are determined by taking a sum total of respective amplitude information Am (sum total of peaks, averages or energies of amplitude information Am) in the respective bands. An output, i.e., a spectrum of sum total of respective bands from the sum total detector 14 is generally called a bark spectrum. The bark spectrum SB in respective bands is as shown in Fig. 4, for example. It is to be noted that, in order to simplify illustration in Fig. 4, the number of bands of the critical bands is represented by twelve bands (B1 to B12).

Here, in order to allow for the influence in the so-called masking of the bark spectrum SB, a predetermined weighting function is convoluted onto the bark spectrum SB (convolution). To realize this, an output from the sum total detector 14, i.e., respective values of the bark spectrum SB are sent to a filter circuit 15. This filter circuit 15 comprises, e.g., a plurality of delay elements for sequentially delaying input data, a plurality of multipliers (e.g., 25 multipliers corresponding to respective bands) for multiplying outputs from these delay elements by filter coefficients (weighting function), and a sum total adder for taking a sum total of respective multiplier outputs. In the respective multipliers of the filter circuit 15, multiplying operation is carried out as follows. For example, at multiplier M corresponding to an arbitrary band, the filter coefficient is multiplied by outputs of respective delay elements; at the multiplier M-1, the filter coefficient 0.15 is multiplied by those outputs; at the multiplier M-2 the filter coefficient 0.0019 is multiplied by those outputs; at the multiplier M-3, the filter coefficient 0.000086 is multiplied by those outputs; at the multiplier M + 1, the filter coefficient 0.4 is multiplied by those outputs; at the multiplier M + 2, the filter coefficient 0.06 is multiplied by those outputs; and at the multiplier M +3, the filter coefficient 0.007 is multiplied by those outputs. Thus, convolution processing of the bark spectrum SB is carried out. It is to be noted that M is an arbitrary integer of 1 to 25. By this convolution processing, sum total of the portion indicated by dotted lines is taken. It is to be noted that the above-mentioned masking refers to the phenomenon that a signal is masked by another signal, and is not heard. As the masking effect, there are the masking effect for an audio signal on the time base and the masking effect for an audio signal on the frequency base. Namely, by this masking effect, even if there is any noise at the portion subject to masking, such a noise will not be heard. For this reason, in an actual audio signal, noise in the portion subject to masking is considered as an allowable noise.

Thereafter, an output of the filter circuit is sent to a subtracter 16. This subtracter 16 serves to determine a level a corresponding to an allowable noise level which will be described later in the convoluted region. It is to be noted that the level a corresponding to the allowable noise level (allowed noise level) is such a level to become in correspondence with the allowed noise level every band of the critical band by carrying out deconvolution processing as described later. Here, an allowed function (function representing the masking level) for determining the level α is delivered to the subtracter 16. By increasing or decreasing this allowed function, control of the level α is carried out. This allowed function is delivered from a function generator 29 which will be described later.

Namely, when the number given in order from a low frequency band of a band the critical bandwidth is assumed to be i, the level a corresponding to the allowed noise level is determined by the following equation:$\text{α = S - (n-ai)}$ where n and a are respectively constants, and S is intensity of a convolution processed bark spectrum. In the above equation, (n-ai) represents an allowed function. In this embodiment, n is set to 38 and a is set to 1. There results no degradation of sound quality at this time. Satisfactory coding is thus carried out.

In this way, the level α is determined. This data is transmitted to a divider 17. This divider 17 serves to apply deconvolution to the level α in the convoluted region. Accordingly, by carrying out this deconvolution, a masking spectrum is provided from the level α. Namely, this masking spectrum becomes an allowed noise spectrum. It is to be noted that while the above-mentioned deconvolution processing requires complicated operation, a simplified divider 17 is used in this embodiment to carry out deconvolution.

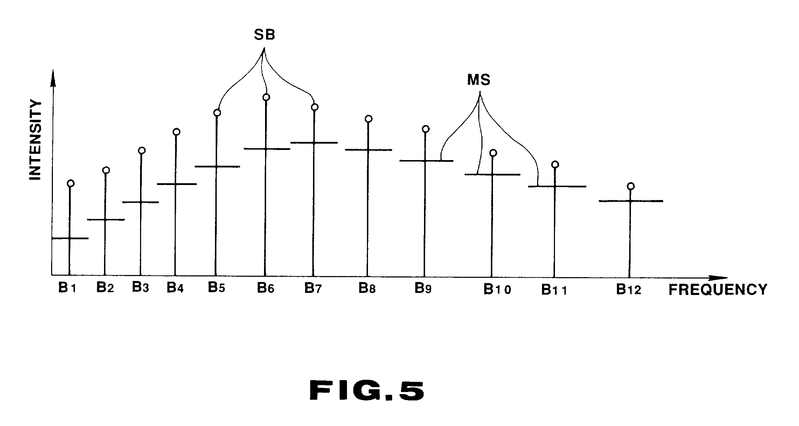

Then, the above-mentioned masking spectrum is transmitted to a subtracter 19 through a synthesis circuit 18. Here, an output of the sum total detector 14, i.e., the previously described bark spectrum SB from the sum total detector 14 is delivered to the subtracter 19 through a delay circuit 21. At this subtracter 19, a subtractive operation between the masking spectrum and the bark spectrum SB is carried. Thus, as shown in Fig. 5, the portion of the bark spectrum SB of which level is lower than the level indicated by the level of the masking spectrum MS is subjected to masking.

An output of the subtracter 19 is delivered to a ROM 30 through an allowed noise level corrector 20. In the ROM 30, a plurality of allocated bit number information used for quantization of the amplitude information Am are stored. This ROM 30 serves to output allocated bit number information corresponding to an output of the subtracter 19 (difference level between energy in respective bands and an output of the noise level setting means. Accordingly, at a quantizer 24, quantization processing of the amplitude information Am is carried out on the basis of the allocated bit number information. An output of the quantizer 24 is outputted from the output terminal 2. It is to be noted that the delay circuit 21 is provided in order to delay a bark spectrum SB from the sum total detector 14 by taking into consideration delay quantities at respective circuits preceding to the synthesis circuit 18. Further, the delay circuit 23 is provided in order to delay the amplitude information Am by taking into consideration delay quantities at respective circuits preceding to the ROM 30.

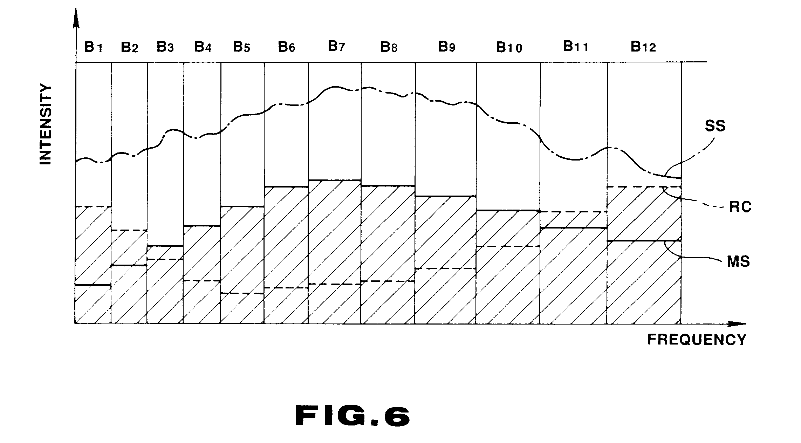

Further, in synthesis at the above-described synthesis circuit 18, it is possible to synthesize data indicating the so-called minimum audible curve RC which is the hearing sense characteristic of the human being as shown in Fig. 6 delivered from a minimum audible curve generator 22 and the masking spectrum MS. In this minimum audible curve, if the noise absolute level is below the minimum audible curve, this noise cannot be heard. Furthermore, even if coding is the same the minimum audible curve would vary in dependency upon variation of a reproducing volume at the time of reproduction. It is to be noted that, since there is not so great variation in the manner in which a music enters, e.g., 16 bit dynamic range in actual digital systems, if it is assumed that quantization noise of, e.g., the frequency band most easily heard to ear in the vicinity of 4 KHz, quantization noise less than the level of the minimum audible curve is considered to be not heard in other frequency bands. Accordingly, when a way of use in which noise, e.g., in the vicinity of 4 KHz of a word length that the system has is not heard is assumed to be employed, and an allowed noise level is provided by synthesizing the minimum audible curve RC and the masking spectrum MS, the allowed noise level in this case is permitted to be the level up to portion indicated by slanting lines in the figure. It is to be noted that, in this embodiment, the level of 4 KHz of the minimum audible curve is caused to be in correspondence with the minimum level corresponding to, e.g., 20 bits. In Fig. 6, signal spectrum SS is shown together.

At the allowed noise level corrector 20, the allowed noise level from the subtracter 19 is corrected on the basis of information of the so-called equi-loudness curve sent from a correction value determination circuit 28. Namely, from the correction value determination circuit 28, correction value information for correcting the allowed noise level from the subtracter 19 on the basis of data of the so-called equi-loudness curve is outputted. This correction value data is transmitted to the allowed noise level correction circuit 20. Thus, a correction in which the equi-loudness curve of the allowed noise level from the subtracter 19 is taken into consideration is made. It is to be noted that the equi-loudness curve is related to the hearing sense of the human being. This curve is obtained by determining sound pressures of sound at respective frequencies, which can be heard at the same intensity as that of a pure sound of, e.g., 1 KHz to connect them. This curve is also called an equi-sensitivity curve of loudness. Further, the equi-loudness curve is substantially the same as the minimum audible curve RC shown in FIG. 6. In this equi-loudness curve, e.g., in the vicinity of 4 KHz, even if the sound pressure is lowered by 8 to 10 dB than that at 1 KHz, sound at that time is heard at the same intensity of a sound at 1 KHz. In contrast, in the vicinity of 50 KHz, if sound pressure is higher than the sound pressure in the vicinity of 1 KHz by about 15 dB, sound is not heard at the same sound pressure. For this reason, it is seen that it is desirable to allow noise above the level of the minimum audible curve (allowed noise level) to have a frequency characteristic given by a curve corresponding to the equi-loudness curve. For such a reason, it is seen that it is adapted for the hearing sense characteristic of the human being to correct the allowed noise level by taking the equi-loudness curve into consideration.

It is to be noted that, in this embodiment, there may be employed a configuration such that the above-described synthesis processing of the minimum audible curve is not carried out. Namely, in this case, minimum audible curve generator 22 and synthesis circuit 18 become unnecessary. An output from the subtracter 16 is subjected to deconvolution at the divider, and is then transmitted directly to the subtracter 19.

In a coding method for a digital signal, an approach is employed to orthogonally transform an input digital signal to divide the orthogonally transformed signal to signal components in critical bands to encode the signal components in the respective critical bands by adaptive allocated bit numbers based on allowed noise levels every respective critical bands, and to transmit floating coefficients obtained by applying block floating processing to the orthogonally transformed signal components. Thus, in the case of carrying out floating processing every small block of which bandwidth is narrower than that of the critical band, an approach is employed to transmit, in place of floating coefficients every respective critical bands, information relating to allowed noise levels every critical bands and word length information of respective small blocks, thereby making it possible to reduce the number of bits for the floating coefficients. Further, in the case of carrying out the block floating processing every large block of which bandwidth is broader than that of the critical band, an approach is employed to transmit information relating to floating coefficients every large blocks, thereby making it possible to reduce the number of bits transmitted.

Furthermore, in the case of carrying out the floating processing every small block of which bandwidth is narrower than that of the critical band, an approach is employed to transmit word length information of one small block of small blocks in respective critical bands, thereby making it possible to reduce the number of word length information. Accordingly, bit compression can be carried out to higher degree.

In addition, in the case of carrying out the floating processing every small block of which bandwidth is narrower than that of the critical band, an approach is employed to transmit information of word lengths corresponding to the numbers of bits allocated every small blocks, and to transmit, in place of floating coefficients every critical bands, information relating to allowed noise levels each of which designation range is shifted in a lower level direction by a predetermined level from a signal level range in the critical band, thereby making it possible to reduce the number of bits for transmission of information relating to allowed noise levels. Accordingly, bit compression can be carried out to higher degree.

## Claims

1. A method of coding a digital signal in which the digital signal is transformed into an orthogonal set of transformed (12) frequency components (Am) occupying critical frequency bands (B) the widths of the critical bands (B) increasing with frequency, the components in the bands being quantized in accordance with the differences between the magnitudes of the components in the bands and the allowed noise levels of the bands the components also occupying frequency blocks (b) the components of the blocks being subject to block floating processing to produce floating coefficients
characterised in that,
a critical band (B) is divided into a plurality of blocks (b₁-b₄) the bandwidths of which are smaller than the bandwidth of the band, the components of the band (B) being represented by a first coding format having bits representing the allowed noise levels of the blocks (b₁-b₄) of the band B and bits representing the word lengths of the components in the blocks (b₁-b₄) of the band B and
a plurality of critical bands (B1-B4) are combined into a block (b) in which the bands (B1-B4) have bandwidths which are smaller than the bandwidth of the block, the components of the block being represented by a second coding format different to the first having bits representing a floating coefficient of the block and by bits representing the word lengths of components in each of the bands (B1-B4).

2. A method according to claim 1, where, in the first coding format, one set of bits represents an allowed noise level associated with the whole band B.

3. A method according to claim 2, wherein another set of bits associated with each block (b1-b4) of the band B represents the difference between the noise level of that block and the noise level of the band.

4. A method according to claim 1, 2 or 3, where, in the second coding format, the components of the block (b) are represented by one set of bits representing one floating coefficient of the block (b) and by a plurality of sets of bits representing the word lengths of components of the respective bands (B1-B4).

5. A method according to any preceding claim, wherein the said transform is DCT.

6. A method according to any preceding claim, wherein the transformed signal occupies 25 bands in a frequency range 0 to 22 kHz.

7. A method according to any preceding claim, wherein the said magnitudes of the components in the band are the respective sums of the amplitudes of the frequency components of the bands.

8. A method according to claim 7, wherein a mask spectrum is derived (15-18) from the said sums, the allowable noise level being dependent on the mask spectrum.

9. A method according to any preceding claim, wherein the said critical band (B) divided into a plurality of blocks is of relatively higher frequency and the said plurality of critical bands (B1-B4) are of relatively lower frequency.

## Patentansprüche

1. Verfahren zur Codierung eines Digitalsignals, bei dem das Digitalsignal in einen orthogonalen Satz transformierter (12) Frequenzkomponenten (Am) transformiert wird, welche kritische Frequenzbänder (B) besetzen, wobei die Breiten der kritischen Bänder (B) mit der Frequenz zunehmen, und wobei die Komponenten in den Bändern quantisiert werden in Übereinstimmung mit Differenzen zwischen der Größe der Komponenten in den Bändern und den zulässigen Rauschpegeln der Bänder der Komponenten, die auch Frequenzblöcke (b) der Komponenten der Blöcke besetzen, die einer Block-Floating-Verarbeitung unterworfen sind, um Floating-Koeffizienten zu erzeugen,
**dadurch gekennzeichnet**, daß ein kritisches Band (B) in mehrere Blöcke (b₁-b₄) aufgeteilt wird, deren Bandbreiten kleiner sind als die Bandbreite des Bandes, wobei die Komponenten des Bandes (B) durch ein erstes Codierformat repräsentiert werden, welches Bits, die die zulässigen Rauschpegel der Blöcke (b₁-b₄) des Bandes (B), und Bits, die die Wortlängen der Komponenten in den Blöcken (b₁-b₄) des Bandes (B) repräsentieren, aufweist, und
daß mehrere der kritischen Bänder (B1-B4) in einen Block (b) zusammengefügt werden, in dem die Bänder (B1-B4) Bandbreiten haben, die kleiner sind als die Bandbreite des Blockes, wobei die Komponenten des Blockes durch ein zweites Codierformat unterschiedlich zu dem ersten Codierformat repräsentiert werden, aufweisend Bits, die einen Floating-Koeffizienten des Blockes repräsentieren, und Bits, die die Wortlängen von Komponenten in jedem der Bänder (B1-B4) repräsentieren.

2. Verfahren gemäß Anspruch 1,
wobei in dem ersten Codierformat ein Satz der Bits einen dem gesamten Band (B) zugeordneten zulässigen Rauschpegel repräsentiert

3. Verfahren gemäß Anspruch 2,
wobei ein weiterer Satz von jedem Block (b₁-b₄) des Bandes (B) zugeordneter Bits die Differenz zwischen dem Rauschpegel des Blockes und dem Rauschpegel des Bandes repräsentiert.

4. Verfahren gemäß Anspruch 1, 2 oder 3,
wobei im zweiten Codierformat die Komponenten des Blockes (b) durch einen Satz von Bits, die einen Floating-Koeffizienten des Blockes (b) repräsentieren, und durch mehrere Sätze von Bits, die die Wortlängen der Komponenten der jeweiligen Bänder (B1-B4) repräsentieren, repräsentiert werden.

5. Verfahren gemäß einem der vorhergehenden Ansprüche,
wobei die Transformation DCT ist.

6. Verfahren gemäß einem der vorhergehenden Ansprüche,
wobei das transformierte Signal 25 Bänder in einem Frequenzbereich von 0 bis 22 kHz belegt.

7. Verfahren gemäß einem der vorhergehenden Ansprüche,
wobei die Größen der Komponenten in dem Band die jeweiligen Summen der Amplituden der Frequenzkomponenten der Bänder sind.

8. Verfahren gemäß Anspruch 7,
wobei das Maskenspektrum von diesen Summen abgeleitet (15-18) ist und der zulässige Rauschpegel abhängig von dem Maskenspektrum ist.

9. Verfahren gemäß einem der vorhergehenden Ansprüche,
wobei das kritische Band (B), das in mehrere Blöcke aufgeteilt wird, eine vergleichsweise hohe Frequenz hat und die mehreren kritischen Bänder (B1-B4) eine vergleichsweise niedrige Frequenz haben.

## Revendications

1. Procédé de codage d'un signal numérique dans lequel le signal numérique est transformé selon un jeu orthogonal de composantes de fréquence (Am) transformées (12) occupant des bandes de fréquences critiques (B), les largeurs des bandes critiques (B) augmentant avec la fréquence, les composantes dans les bandes étant quantifiées conformément aux différences entre les amplitudes des composantes dans les bandes et les niveaux de bruit autorisés des bandes, les composantes occupant également des blocs de fréquence (b), les composantes des blocs étant soumises à un traitement de bloc flottant afin de produire des coefficients flottants,
caractérisé en ce que :
une bande critique (B) est divisée en une pluralité de blocs (b₁-b₄) dont les largeurs de bande sont inférieures à la largeur de bande de la bande, les composantes de la bande (B) étant représentées par un premier format de codage comportant des bits représentant les niveaux de bruit autorisés des blocs (b₁-b₄) de la bande B et des bits représentant les longueurs de mot des composantes dans les blocs (b₁-b₄) de la bande B ; et
une pluralité de bandes critiques (B1-B4) sont combinées dans un bloc (b) dans lequel les bandes (B1-B4) présentent des largeurs de bande qui sont inférieures à la largeur de bande du bloc, les composantes du bloc étant représentées par un second format de codage différent du premier comportant des bits représentant un coefficient flottant du bloc et des bits représentant les longueurs de mot des composantes dans chacune des bandes (B1-B4).

2. Procédé selon la revendication 1, dans lequel, dans le premier format de codage, un jeu de bits représente un niveau de bruit autorisé associé à la totalité de la bande B.

3. Procédé selon la revendication 2, dans lequel un autre jeu de bits associé à chaque bloc (b1-b4) de la bande B représente la différence entre le niveau de bruit de ce bloc et le niveau de bruit de la bande.

4. Procédé selon les revendications 1, 2 ou 3, dans lequel, dans le second format de codage, les composantes du bloc (b) sont représentées par un jeu de bits représentant un coefficient flottant du bloc (b) et par une pluralité de jeux de bits représentant les longueurs de mot des composantes des bandes respectives (B1-B4).

5. Procédé selon l'une quelconque des revendications précédentes, dans lequel ladite transformation est une DCT.

6. Procédé selon l'une quelconque des revendications précédentes, dans lequel le signal transformé occupe 25 bandes dans une plage de fréquences de O à 22 kHz.

7. Procédé selon l'une quelconque des revendications précédentes, dans lequel lesdites intensités des composantes dans la bande sont les sommes respectives des amplitudes des composantes de fréquence des bandes.

8. Procédé selon la revendication 7, dans lequel un spectre de masque est dérivé (15-18) desdites sommes, le niveau de bruit autorisé étant dépendant du spectre de masque.

9. Procédé selon l'une quelconque des revendications précédentes, dans lequel ladite bande critique (B) divisée en une pluralité de blocs présente une fréquence relativement élevée et les bandes de ladite pluralité de bandes critiques (B1-B4) présentent une fréquence relativement basse.
